# EUROPEAN PATENT APPLICATION

(11) **EP 3 131 199 A1**
(43) Date of publication of application: **15.02.2017**
(21) Application number: 15180490.3
(22) Date of filing: 11.08.2015
(51) Int. Cl.: H03F 1/02, H03F 3/19, H03F 3/21, H03F 3/60

(54) **N-WAY LOAD MODULATION AMPLIFIER**

(71) Applicant: Nokia Solutions and Networks GmbH & Co. KG, 81541 Munich (DE)
(72) Inventor: Borst, Karlheinz, 80807 München (DE)

(57) **Abstract**

There is provided a technique for N-way load modulation amplification, particularly an N-way load modulation amplifier with a star-like network combining structure. Such technique comprising: a load modulation amplification structure (LMAS) for amplifying an input signal, including a main amplifier and a plurality of at least two peak amplifiers, which are connected in parallel to each other, wherein the main amplifier and the plurality of peak amplifiers are arranged to interact in a load modulation operation, and a star-like combining structure (CS) for generating an output signal by combining outputs of the load modulation amplification structure (LMAS), including at least four quarter-wavelength impedance transformers, wherein at least three of the transformers are connected to a respective one of the main amplifier and the plurality of peak amplifiers of the load modulation amplification structure (LMAS), one of the transformers is connected to an output of the combining structure, and all of the transformers are connected in a star-like manner to a common node (CN).

## Description

### Field

The present invention relates to an apparatus for N-way load modulation amplification. More specifically, the present invention relates to an N-way load modulation amplifier with a star-like network combining structure, and its operation.

### Background

High power amplifier designs for multi-standard (MS), multi-carrier (MC) and even multi-band (MB) communication systems show a challenging task when high efficiency is required, especially in a back-off region. Several well-proven design ideas exist like, for example, Doherty amplifier, envelope tracking, outphasing and so on.

The Doherty amplifier is the most common representative of power amplifiers using a load modulation principle. The load modulation principle is a special type of amplifying principle in which load changes of the so-called main amplifier are accomplished by switching on/off one or more additional peak amplifier(s). A characteristic element of a Doherty amplifier is a quarter-wavelength impedance transformer connecting the outputs of the main amplifier and the peak amplifier(s) to generate and present power-efficient impedance levels to the main amplifier through the load changes. It is noted that the term 'wavelength' used above refers to the operating center frequency of the Doherty amplifier.

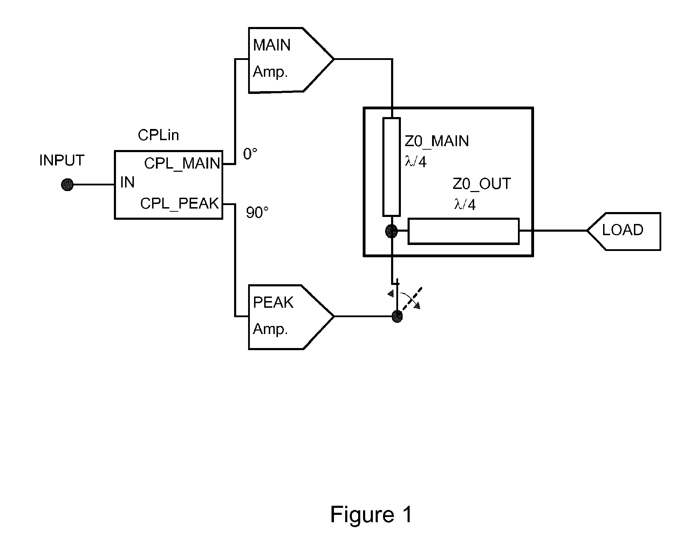

An example of a known Doherty amplifier is shown in Figure 1, which has one peak amplifier (wherein the switch is only depicted for schematic illustration). As shown in Figure 1, a coupler of the Doherty amplifier couples a portion of the input signal for amplification to the main amplifier and another portion of the input signal for amplification to the peak amplifier, wherein the peak-amplifier signal is phase-shifted by 90° with respect to the main-amplifier signal (corresponding to a quarter wavelength denoted by λ/4). As evident, a Doherty amplifier is characterized by a quarter-wavelength line on the input side (for generating the 90° phase shift for CPL_PEAK) and a corresponding quarter-wavelength impedance transformer between the output of main amplifier and its connecting point with the output of the peak amplifier.

However, such Doherty amplifier (like all of the above-mentioned amplifier concepts) suffers from the ability to generate high power levels in a very power efficient way, especially in a back-off region, over a significantly large range of frequencies.

In the past, efficient multi-band (MB) applications came into the design development focus. Together with increasing demands for shrinked size and effective use of resources, the implementation of broadband high-capability digital predistortion systems require corresponding broadband, high-power amplification stages. To this end, the conventional solution was to use more than one high-efficient amplifier, like a Doherty amplifier, in parallel to cover the desired frequency bands. That is to say, parallelization of known amplifier types has been conventionally proposed to cover the desired frequency bands. Yet, even such parallelized amplifier structures are not capable of generating high-power and broadband output signals, especially high-power and broadband output signals with a high peak-to-average ratio (PAR), in an efficient manner.

Accordingly, there is a demand for an improvement for N-way load modulation amplification.

### Summary

Various exemplifying embodiments of the present invention aim at addressing at least part of the above issues and/or problems and drawbacks.

Various aspects of exemplifying embodiments of the present invention are set out in the appended claims.

According to an example aspect of the present invention, there is provided an apparatus comprising an apparatus, comprising: a load modulation amplification structure for amplifying an input signal, including a main amplifier and a plurality of at least two peak amplifiers, which are connected in parallel to each other, wherein the main amplifier and the plurality of peak amplifiers are arranged to interact in a load modulation operation, and a star-like combining structure for generating an output signal by combining outputs of the load modulation amplification structure, including at least four quarter-wavelength impedance transformers, wherein at least three of the transformers are connected to a respective one of the main amplifier and the plurality of peak amplifiers of the load modulation amplification structure, one of the transformers is connected to an output of the combining structure, and all of the transformers are connected in a star-like manner to a common node.

According to an example aspect of the present invention, there is provided a method of operating a load modulation amplifier apparatus, said apparatus comprising: a load modulation amplification structure for amplifying an input signal, including a main amplifier and a plurality of at least two peak amplifiers, which are connected in parallel to each other, wherein the main amplifier and the plurality of peak amplifiers are arranged to interact in a load modulation operation, and a star-like combining structure for generating an output signal by combining outputs of the load modulation amplification structure, including at least four quarter-wavelength impedance transformers, wherein at least three of the transformers are connected to a respective one of the main amplifier and the plurality of peak amplifiers of the load modulation amplification structure, one of the transformers is connected to an output of the combining structure, and all of the transformers are connected in a star-like manner to a common node, the method comprising: activating a predefined set of the plurality of peak amplifiers at predetermined back-off points.

According to an example aspect of the present invention, there is provided a computer program product comprising computer-executable computer program code which, when the computer program code is executed on a computer, is configured to cause the computer to carry out the method according to the above method-related example aspect (i.e. to operate the load modulation amplifier apparatus according to the above apparatus-related example aspect).

Further developments and/or modifications of the aforementioned example aspects of the present invention are set out in the following.

By way of exemplifying embodiments of the present invention, an improvement for N-way load modulation amplification can be achieved. More specifically, high-power and broadband output signals, especially high-power and broadband output signals with a high peak-to-average ratio (PAR), can be generated in an efficient manner.

### Brief Description of the drawings

These and other objects, features, details and advantages will become more fully apparent from the following detailed description of embodiments of the present invention which is to be taken in conjunction with the appended drawings, in which:
Figure 1 is a schematic diagram illustrating an example of the structure of a conventional Doherty amplifier.
Figure 2 is a schematic diagram illustrating an example of the structure of an N-way load modulation amplifier with a star-like network combining structure according to exemplifying embodiments of the present invention.
Figure 3 is a schematic diagram illustrating an example of the structure of a 4-way load modulation amplifier with a star-like network combining structure according to exemplifying embodiments of the present invention.
Figure 4 is a schematic diagram illustrating an example of the operating state of the 4-way load modulation amplifier at back-off point BO3 according to exemplifying embodiments of the present invention.
Figure 5 is a schematic diagram illustrating an example of the operating state of the 4-way load modulation amplifier at back-off point BO2 according to exemplifying embodiments of the present invention.
Figure 6 is a schematic diagram illustrating an example of the operating state of the 4-way load modulation amplifier at back-off point BO1 according to exemplifying embodiments of the present invention.
Figure 7 is a schematic diagram illustrating an example of the operating state of the 4-way load modulation amplifier at maximum power point PMAX according to exemplifying embodiments of the present invention.
Figure 8 shows graphs illustrating simulation examples indicating the load modulation characteristics (load impedances) for the main and peak amplifiers in the various operating states of the 4-way load modulation amplifier according to exemplifying embodiments of the present invention.
Figure 9 shows graphs illustrating simulation examples indicating the return losses (corresponding to the load impedances shown in Figure 8) for the main and peak amplifiers in the various operating states of the 4-way load modulation amplifier according to exemplifying embodiments of the present invention.
Figure 10 shows a graph illustrating simulation examples indicating the output return loss in the various operating states of the 4-way load modulation amplifier according to exemplifying embodiments of the present invention.

### Detailed Description

The present invention is described herein with reference to particular non-limiting examples and to what are presently considered to be conceivable embodiments of the present invention. A person skilled in the art will appreciate that the present invention is by no means limited to these examples and embodiments, and may be more broadly applied.

It is to be noted that the following description of the present invention and its embodiments mainly refers to explanations being used as non-limiting examples for exemplifying purposes. As such, the description of exemplifying embodiments given herein specifically refers to terminology which is related thereto. Such terminology is only used in the context of the presented non-limiting examples, and does naturally not limit the present invention in any way. Rather, any other structures, elements, modules, functionalities, etc. may also be utilized, as long as complying with what is described herein and/or exemplifying embodiments described herein are applicable to it.

Hereinafter, various exemplifying embodiments and implementations of the present invention and its aspects are described using several variants and/or alternatives. It is generally noted that, according to certain needs and constraints, all of the described variants and/or alternatives may be provided alone or in any conceivable combination (also including combinations of individual features of the various variants and/or alternatives). In this description, the words "comprising" and "including" should be understood as not limiting the described exemplifying embodiments and implementations to consist of only those features that have been mentioned, and such exemplifying embodiments and implementations may also contain features, structures, elements, modules, functionalities etc. that have not been specifically mentioned.

In the drawings, it is noted that lines/arrows interconnecting individual blocks or entities are generally meant to illustrate an operational coupling there-between, which may be a physical and/or logical coupling, which on the one hand is implementation-independent (e.g. wired or wireless) and on the other hand may also comprise an arbitrary number of intermediary functional blocks or entities not shown.

According to exemplifying embodiments of the present invention, in general terms, there is provided a technique for N-way load modulation amplification, particularly an N-way load modulation amplifier with a star-like network combining structure.

As outlined above, the present invention is useful for power amplifier types using a load modulation principle, which is characterized by defined changes in load impedances versus amplitude during operation, wherein the defined changes can be done for example by switching varactor diodes or by switching on and off auxiliary boosting amplifiers in dependence of signal level to be amplified.

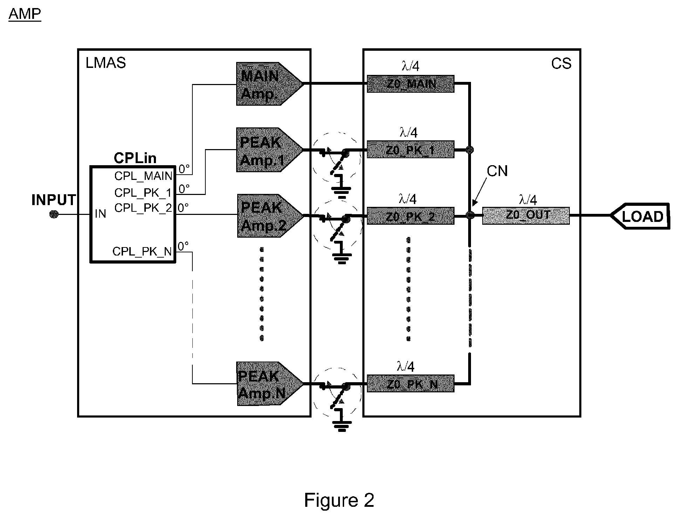

Figure 2 is a schematic diagram illustrating an example of the structure of an N-way load modulation amplifier (or, stated in other words, an apparatus for N-way load modulation amplification) with a star-like network combining structure according to exemplifying embodiments of the present invention.

As shown in Figure 2, an apparatus (AMP) according to exemplifying embodiments of the present invention comprises a load modulation amplification structure (LMAS) for amplifying an input signal and a star-like combining structure (CS) for generating an output signal by combining outputs of the load modulation amplification structure. The load modulation amplification structure (LMAS) includes a main amplifier and a plurality of M (M being at least two) peak amplifiers, which are connected in parallel to each other, wherein the main amplifier and the plurality of peak amplifiers are arranged to interact in a load modulation operation. The star-like combining structure (CS) includes at least four quarter-wavelength impedance transformers (Z0), wherein at least three of the transformers are connected to a respective one of the main amplifier and the plurality of peak amplifiers of the load modulation amplification structure, one of the transformers is connected to an output of the combining structure, and all of the transformers are connected in a star-like manner to a common node (CN).

Accordingly, the star-like combining structure (CS) comprises a number of N inputs or input port (N = M+1) and a single output or output port. Thus, the at least four transformers in the combining structure (CS) build up a so-called STAR-structure.

In Figure 2, the input of Z0_MAIN is connected to the output of the main amplifier, and its output is connected to the common node. Further, the input of any one of Z0_PEAK_i (i = 1...N) is connected to the output of a respective peak amplifier, and its output is connected to the common node, respectively. Still further, the input of Z0_OUT is connected to the common node, and its output is connected to the output of the combining structure, which as such is connectable to an external load. It is to be noted that the switches between respective pairs of peak amplifier and transformer are only depicted for schematic illustration of an ideal ON/OFF condition of the respective peak amplifiers, while the real ON/OFF condition (activation or deactivation) of the respective peak amplifier), is controlled based on predetermined back-off points described later and/or the matching structure of the respective peak amplifier. That is, the peak amplifiers are (controlled to be) matched to connect-through the amplifier branch towards the common node in their respective ON condition (activation), and to short-circuit (i.e. to show a short circuit at their outputs, as exemplified by way of connection to a ground potential in the drawings) in their respective OFF condition (deactivation). As described later, the predetermined back-off points (for activating a predefined set of the plurality of peak amplifiers) may be defined on the basis of one or more of the desired power level of the output signal and amplification factors of the peak amplifiers.

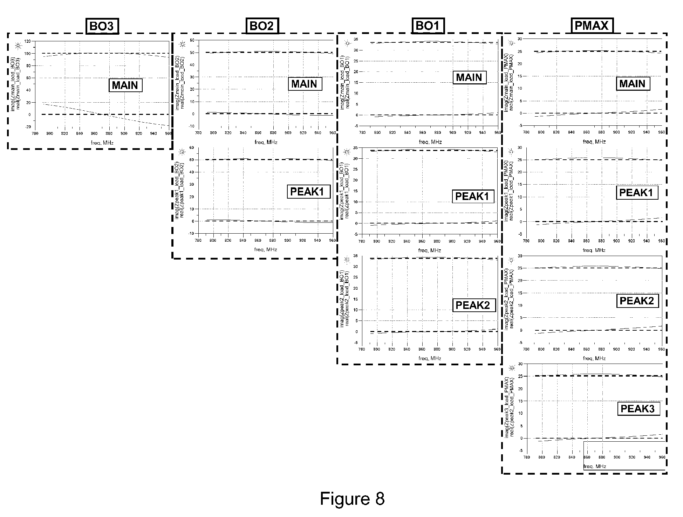

It is noted that the values of the individual impedance transformers (Z0_xx) can be adjusted depending on certain (e.g. operation) requirements and/or (e.g. implementation) conditions. For example, in case of a realization on a printed wiring board (PWB), practical values for the individual impedance transformers (Z0_xx) can depend on the board material. Typically, the impedance values thereof range between about 10 and 70 Ohm. For some exemplary values, reference is made to the description of Figure 8 below.

As shown in Figure 2, the load modulation amplification structure (LMAS) may also include a coupler (CPLin) for receiving the input signal (from an external input) and coupling (via respective coupler outputs denoted by CPL_MAIN, CPL_PK_1, CPL_PK_2, ..., CPL_PK_N) respective portions of the input signal to the main amplifier and the plurality of peak amplifiers of the load modulation amplification structure such that all of the coupled portions of the input signal have the same phase (here, 0° for example). Accordingly, in contrast to a Doherty amplifier, the main-amplifier signal and the peak-amplifier signals are in-phase such that the main amplifier and the plurality of peak amplifiers of the load modulation amplification structure (LMAS) are arranged to amplify respective in-phase portions of the input signal.

According to exemplifying embodiments of the present invention, the N-way load modulation amplifier (as exemplarily illustrated in Figure 2) can be operated by activating a predefined set of the plurality of peak amplifiers at predetermined back-off points (which may be defined on the basis of one or more of the desired power level of the output signal and amplification factors of the peak amplifiers). In operation, the main amplifier and the plurality of peak amplifiers of the load modulation amplification structure (are operated to) amplify respective in-phase portions of the input signal. Also, respective portions of the input signal are coupled to the main amplifier and the plurality of peak amplifiers of the load modulation amplification structure such that all of the coupled portions of the input signal have the same phase.

In contrast to conventional solutions outlined above, the combining principle according to the present invention is not based on a simple quarter-wavelength impedance transformer, and therefore significantly differs from the known 'Doherty Amplifier' principle. Rather, the presented combining structure according to exemplifying embodiments of the present invention is based on a STAR-network combining structure build up of at least four quarter-wavelength impedance transformer circuits. In a similar manner as described above, the 'wavelength' refers to the operating center frequency of the amplifier. This structure makes it possible to achieve a very broadband amplifier operation which is a completely different feature to the common principle of a Doherty amplifier.

In particular, the present invention is based on an N-way amplifier structure (with N≥3) in combination with a special output combining principle. The N-way amplifier structure comprises a main amplifier (a main amplifier stage/branch) and at least two peak amplifiers (at least two peak amplifier stages/branches) which are boosting the output signal at high output power levels.

The amplification factors (or power capabilities) of the peak amplifiers are defined by the (power) factor αₚₖ₁, αₚₖ₂, ..., α_{pkN} relative to the main amplifier power contribution.

If there is considered a graph showing output power versus input power, there are distinct characteristic points where the different peak amplifiers start to operate (i.e. become activated) and support the main amplifier. Another characteristic point is defined when both of the main amplifier and all of the peak amplifiers reach their maximum power leading to the combined maximum output power (PMAX) of the amplifier.

The operating points where the different peak amplifiers start to operate (i.e. become active) are referred to as back-off (BO1, BO2, ..., BON) points. These points depend on the amplification factors (or power capabilities) of the peak amplifiers, i.e. αₚₖ₁, αₚₖ₂, ..., α_{pkN}. All amplifier paths are subjected to impedance variations during power changes. These impedances can be specified at the BO-points and the PMAX-point and are also a function of ₚₖ₁, αₚₖ₂, ..., α_{pkN}. Knowing these conditions, it is possible to design a combining structure that fulfils the constraints for the impedances exactly for one frequency point and to a remarkable extent for a wide range of frequencies.

In the following, without loss of generality, a specific example of a 4-way load modulation amplifier (with N=4 and M=3) according to exemplifying embodiments of the present invention is described in more detail for illustrative purposes. While any power contribution/distribution is possible (by adjustment of ₚₖ₁, αₚₖ₂, ..., α_{pkN}), a power contribution/distribution of 1:1:1:1 (i.e. an equal contribution from all of the main and peak amplifiers) is hereinafter assumed as a non-limiting design example.

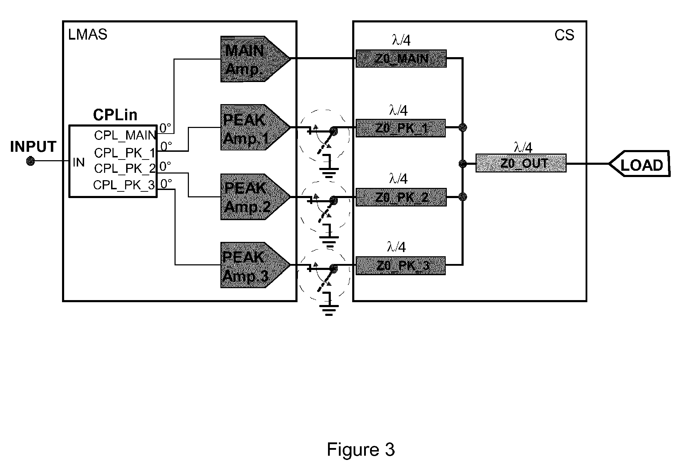

Figure 3 is a schematic diagram illustrating an example of the structure of a 4-way load modulation amplifier with a star-like network combining structure according to exemplifying embodiments of the present invention. For details, reference is made to the above description of Figure 2, which is applicable, taking into consideration that N=4 and M=3 holds in the present example.

Below, four specific operating states or working points of the amplifier are taken into consideration for comparative purposes.

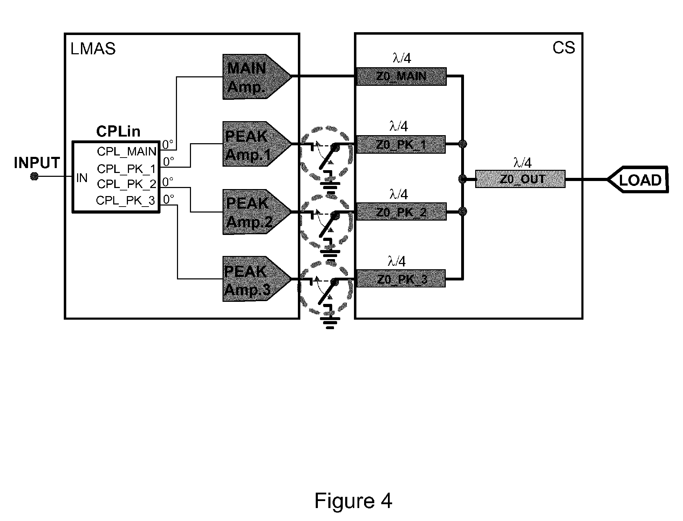

Figure 4 is a schematic diagram illustrating an example of the operating state of the 4-way load modulation amplifier at back-off point BO3 according to exemplifying embodiments of the present invention. At back-off point BO3, the main amplifier is ON, the first peak amplifier PEAK1 is OFF, the second peak amplifier PEAK2 is OFF, and the third peak amplifier PEAK3 is OFF. That is, only the main amplifier operates to amplify the input signal. Accordingly, roughly speaking, an output power level in a lowest one of four ranges can be achieved.

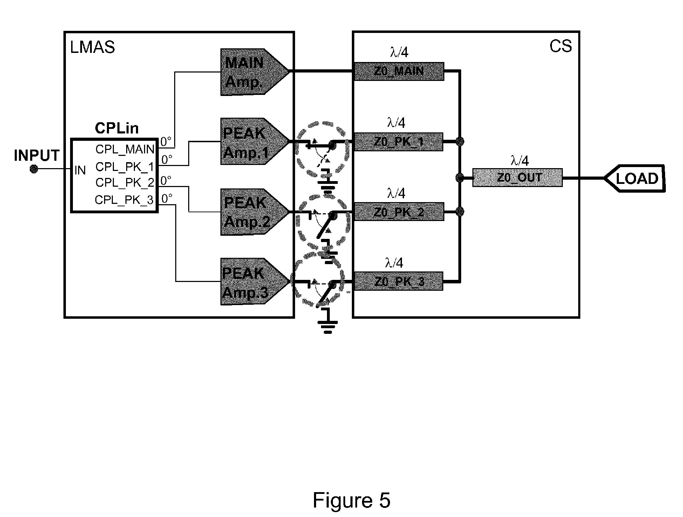

Figure 5 is a schematic diagram illustrating an example of the operating state of the 4-way load modulation amplifier at back-off point BO2 according to exemplifying embodiments of the present invention. At back-off point BO2, the main amplifier is ON, the first peak amplifier PEAK1 is ON, the second peak amplifier PEAK2 is OFF, and the third peak amplifier PEAK3 is OFF. That is, the main amplifier and the first peak amplifier operate to amplify the input signal. Accordingly, roughly speaking, an output power level in a second-lowest one of four ranges can be achieved.

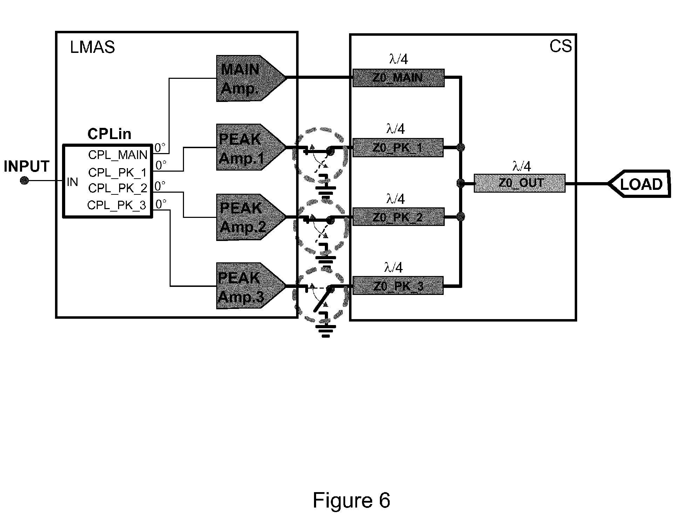

Figure 6 is a schematic diagram illustrating an example of the operating state of the 4-way load modulation amplifier at back-off point BO1 according to exemplifying embodiments of the present invention. At back-off point BO1, the main amplifier is ON, the first peak amplifier PEAK1 is ON, the second peak amplifier PEAK2 is ON, and the third peak amplifier PEAK3 is OFF. That is, the main amplifier and the first and second peak amplifiers operate to amplify the input signal. Accordingly, roughly speaking, an output power level in a second-highest one of four ranges can be achieved.

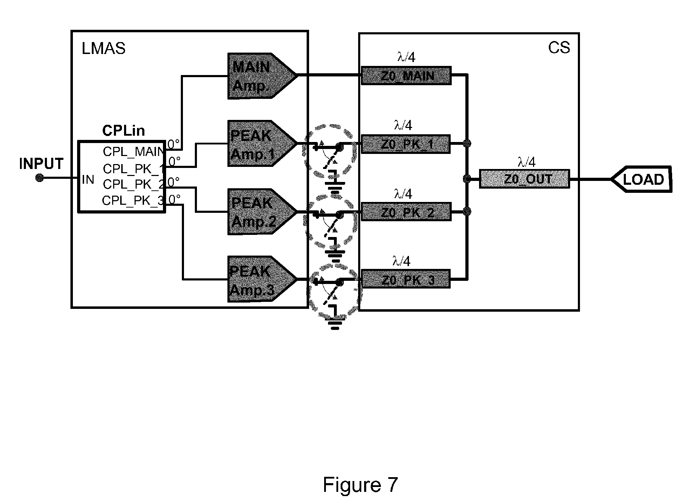

Figure 7 is a schematic diagram illustrating an example of the operating state of the 4-way load modulation amplifier at maximum power point PMAX according to exemplifying embodiments of the present invention. At maximum power point PMAX, the main amplifier is ON, the first peak amplifier PEAK1 is ON, the second peak amplifier PEAK2 is ON, and the third peak amplifier PEAK3 is ON. That is, all of the main and peak amplifiers operate to amplify the input signal. Accordingly, roughly speaking, an output power level in a highest one of four ranges (up to the maximum output power) can be achieved.

Figure 8 shows graphs illustrating simulation examples indicating the load modulation characteristics (load impedances) for the main and peak amplifiers in the various operating states of the 4-way load modulation amplifier according to exemplifying embodiments of the present invention.

All of the graphs in Figure 8 show load impedance versus frequency (in the range from 780 MHz to 960 MHz), wherein the lower curves represent the imaginary part (of the load impedance at the respective CS input), and the upper curves represent the real part (of the load impedance at the respective CS input), respectively.

In the first column from the left, the characteristics of the main amplifier at back-off point BO3 are depicted in a graph. In the second column from the left, the characteristics of the main amplifier and the first peak amplifier at back-off point BO2 are depicted in respective graphs. In the third column from the left, the characteristics of the main amplifier and the first and second peak amplifiers at back-off point BO1 are depicted in respective graphs. In the fourth column from the left, the characteristics of the main amplifier and all of the peak amplifiers at maximum power point PMAX are depicted in respective graphs.

For back-off point BO3, the load impedances are plotted in the range between -20 and 120 Ohm, and the target values (indicated by straight dashed lines) are 0 Ohm for the imaginary part and 100 Ohm for the real part for the activated amplifier. For back-off point BO2, the load impedances are plotted in the range between -10 and 60 Ohm, and the target values (indicated by straight dashed lines) are 0 Ohm for the imaginary part and 50 Ohm for the real part for any one of the activated amplifiers. For back-off point BO1, the load impedances are plotted in the range between -5 and 35 Ohm, and the target values (indicated by straight dashed lines) are 0 Ohm for the imaginary part and 33.3 Ohm for the real part for any one of the activated amplifiers. For maximum power point PMAX the load impedances are plotted in the range between -5 and 30 Ohm, and the target values (indicated by straight dashed lines) are 0 Ohm for the imaginary part and 25 Ohm for the real part for any one of the activated amplifiers.

From the comparison of the graphs in Figure 8, it can be seen that the target values of the respective load impedances can be well approximated over a remarkable/relevant frequency range in all of the various operating states.

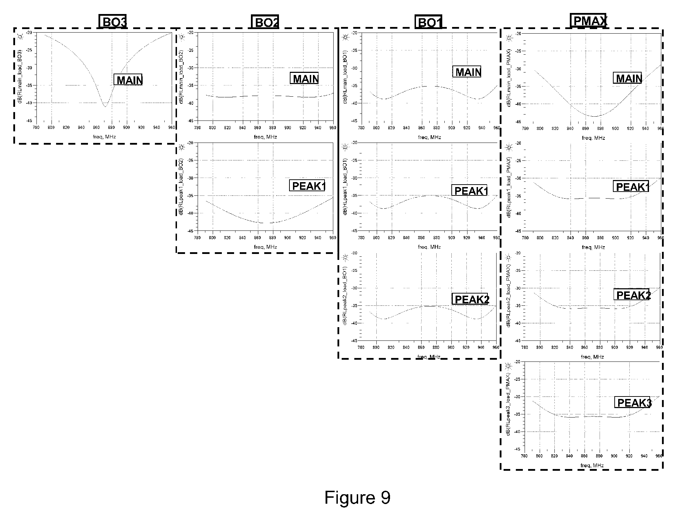

Figure 9 shows graphs illustrating simulation examples indicating the return losses (corresponding to the load impedances shown in Figure 8) for the main and peak amplifiers in the various operating states of the 4-way load modulation amplifier according to exemplifying embodiments of the present invention.

All of the graphs in Figure 9 show return losses (in the range between -45 dB and -20 dB) versus frequency (in the range from 780 MHz to 960 MHz), respectively.

In the first column from the left, the characteristics of the main amplifier at back-off point BO3 are depicted in a graph. In the second column from the left, the characteristics of the main amplifier and the first peak amplifier at back-off point BO2 are depicted in respective graphs. In the third column from the left, the characteristics of the main amplifier and the first and second peak amplifiers at back-off point BO1 are depicted in respective graphs. In the fourth column from the left, the characteristics of the main amplifier and all of the peak amplifiers at maximum power point PMAX are depicted in respective graphs.

From the comparison of the graphs in Figure 9, it can be seen that appropriate/ suitable return losses in the range between -45 dB and -20 dB can be achieved over a remarkable/relevant frequency range in all of the various operating states.

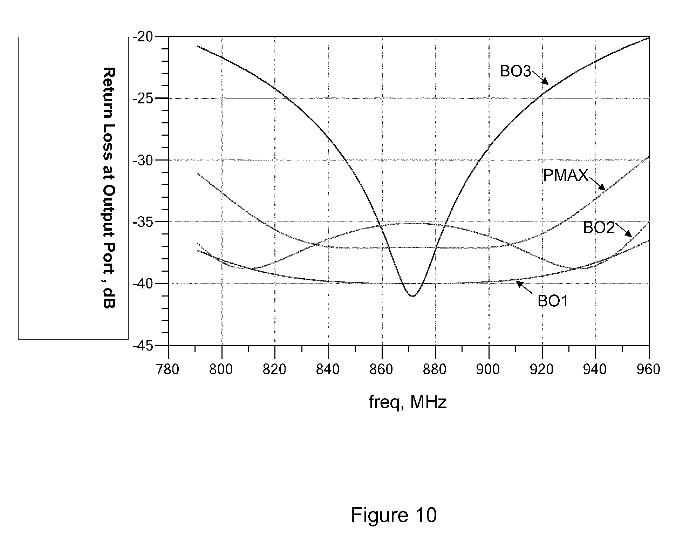

Figure 10 shows a graph illustrating simulation examples indicating the output return loss in the various operating states of the 4-way load modulation amplifier according to exemplifying embodiments of the present invention. The 'output return loss" represents the return loss at the output (or, output port) of the combining structure of the 4-way load modulation amplifier according to exemplifying embodiments of the present invention.

The graph in Figure 10 shows the overall return loss at the output (or output port) of the combing structure (in the range between -45 dB and -20 dB) versus frequency (in the range from 780 MHz to 960 MHz) for the overall 4-way load modulation amplifier.

From Figure 10, it can be seen that an appropriate/suitable overall return loss in the range between -45 dB and -20 dB can be achieved over a remarkable/relevant frequency range in all of the various operating states.

As can be seen from the above, the N-way load modulation power amplifier according to exemplifying embodiments of the present invention can be adjusted to reach suitable alignment to target values over a remarkable/relevant band and even at the edges of the band, being highly flexible/variable and suitable even for broadband applications.

Generally, the present invention and its embodiments can be realized in various implementation structures. This generally holds for all structures, elements, modules, functionalities, etc.

For example, the combining structure according to exemplifying embodiments of the present invention as described above can be realized by several implementation structures. For example, lumped elements, discrete or distributed stripline/microstrip structures may be used. Due to its symmetry properties, the combining structure according to exemplifying embodiments of the present invention is also suited to be completely or partly integrated in the package of transistor devices forming a very dense way to build up a high-power amplifier. For discrete designs, a favorite design is a compact stripline structure which combines power capability, very low losses, as well as possible small size in one component. This is particularly feasible, as there are several vendors in the market that can build-up a compact component that fulfills the task.

Relevant use cases of the N-way load modulation power amplifier according to exemplifying embodiments of the present invention include high-power multiband applications where an N-way amplifier is needed to achieve the requested power levels with reasonable efficiency. The currently available transistors are of course limited in power, but the needs for higher power grow up. So, one of the most suitable design methods can be to combine a main stage with some boosting stages. Therefore, the present invention and its exemplifying embodiments is best suited to solve that task.

As described above, exemplifying embodiments of the present invention provide a novel design principle for N-way load modulation amplification, i.e. an N-way load modulation (power) amplifier. Such N-way load modulation amplification principle is effective for broadband, high-efficiency and high-PAR applications. Namely, high-power and broadband output signals, especially high-power and broadband output signals with a high peak-to-average ratio (PAR), can be handled/generated in an efficient manner.

Accordingly, the N-way load modulation power amplifier according to exemplifying embodiments of the present invention can be utilized in any multi-standard (MS), multi-carrier (MC) and even multi-band (MB) communication systems. Considering certain non-limiting examples, the N-way load modulation power amplifier according to exemplifying embodiments of the present invention can be suitably used in radio access network (RAN) entities such as Remote Radio Heads (RRHs), Radio Frequency Modules (RFMs), or the like in any present or future mobile/wireless communication system, especially any MS and/or MC and/or MB mobile/wireless communication system.

In view of the above, the proposed principle of the N-way load modulation (power) amplifier having the proposed combining structure provides a number of advantages, including for example the following:
- the proposed STAR-combining structure is very broadband or, stated in other words, suitable for broadband applications, i.e. able to handle for example dual-band signals simultaneously,
- the proposed STAR-combining structure works for symmetrical designs (e.g. 1:1:1 power contribution/distribution of main and two peak amplifiers in a 3-way embodiment) as well as for asymmetrical designs (e.g. 1:X:Y power contribution/distribution of main and two peak amplifiers in a 3-way embodiment, for example with X=2 and Y=2 in the exemplary case of αₚₖ₁=αₚₖ₂=2),
- the proposed STAR-combining structure can be realized in several ways (e.g. by lumped elements, discrete components or distributed structures for example in stripline or microstrip realizations (wherein, due to size advantages, realization as a discrete stripline component (e.g. a commercially available coupling component such as a hybrid) may be one of a preferred implementation),
- the proposed STAR-combining structure can be completely or partly realized within a transistor device package (wherein symmetry conditions of the structure are helpful in such implementation),
- output impedance levels of the main and peak amplifiers are not restricted to any values (only to practical limits), wherein e.g. lower values than 50 Ohm are also possible,
- characteristic impedance values of individual components can be best evaluated and adjusted by an optimization program/algorithm/etc. with respect to one or more of bandwidth requirements, goal weighting targets, or the like, and
- there is no need for an additional quarter-wavelength line on the input side, since the main and peak amplifiers all operate in-phase, and therefore, due to the in-phase situation, crosstalk between the amplifier branches is not an issue (however, for practical designs, some phase adjustment lines on the input side may be applicable so as to ensure the in-phase situation).

In general, it is to be noted that respective functional blocks or elements according to above-described aspects can be implemented by any known means, either in hardware and/or software, respectively, if it is only adapted to perform the described functions of the respective parts.

For the purpose of the present invention and its exemplifying embodiments, as described herein above, it should be noted that
- any functionality and/or any operation or control step is suitable to be implemented as software or by hardware without changing the idea of the present invention;
- any such software may be software code independent and can be specified using any known or future developed programming language, such as e.g. Java, C++, C, and Assembler, as long as the functionality defined by the method steps is preserved, wherein software in the sense of the present description comprises software code as such comprising code means or portions or a computer program or a computer program product for performing the respective functions, as well as software (or a computer program or a computer program product) embodied on a tangible medium such as a computer-readable (storage) medium having stored thereon a respective data structure or code means/portions or embodied in a signal or in a chip, potentially during processing thereof,
- any such hardware may be hardware type independent and can be implemented, as described below;
- devices, units or means likely to be implemented as hardware components at the above-defined apparatuses, or any module(s) thereof, (e.g., devices carrying out the functions of the apparatuses according to the embodiments as described above) are hardware independent and can be implemented using any known or future developed hardware technology or any hybrids of these, such as MOS (Metal Oxide Semiconductor), CMOS (Complementary MOS), BiMOS (Bipolar MOS), BiCMOS (Bipolar CMOS), ECL (Emitter Coupled Logic), TTL (Transistor-Transistor Logic), etc., using for example ASIC (Application Specific IC (Integrated Circuit)) components, FPGA (Field-programmable Gate Arrays) components, CPLD (Complex Programmable Logic Device) components or DSP (Digital Signal Processor) components;
- devices, units or means (e.g. the above-defined apparatuses, or any one of their respective units/means) can be implemented as individual devices, units or means, but this does not exclude that they are implemented in a distributed fashion throughout the system, as long as the functionality of the device, unit or means is preserved;
- an apparatus may be represented by a semiconductor chip, a chipset, or a (hardware) module comprising such chip or chipset; this, however, does not exclude the possibility that a functionality of an apparatus or module, instead of being hardware implemented, be implemented as software in a (software) module such as a computer program or a computer program product comprising executable software code portions for execution/being run on a processor; and
- a device may be regarded as an apparatus or as an assembly of more than one apparatus, whether functionally in cooperation with each other or functionally independently of each other but in a same device housing, for example.

Such and similar principles are to be considered as known to a skilled person.

In view of the above, there is provided a technique for N-way load modulation amplification, particularly an N-way load modulation amplifier with a star-like network combining structure. Such technique exemplarily comprises an apparatus and an operating method thereof, said apparatus comprising: a load modulation amplification structure for amplifying an input signal, including a main amplifier and a plurality of at least two peak amplifiers, which are connected in parallel to each other, wherein the main amplifier and the plurality of peak amplifiers are arranged to interact in a load modulation operation, and a star-like combining structure for generating an output signal by combining outputs of the load modulation amplification structure, including at least four quarter-wavelength impedance transformers, wherein at least three of the transformers are connected to a respective one of the main amplifier and the plurality of peak amplifiers of the load modulation amplification structure, one of the transformers is connected to an output of the combining structure, and all of the transformers are connected in a star-like manner to a common node.

Even though the present invention is described above with reference to exemplifying embodiments and specific examples according to the accompanying drawings, which are provided for illustrative purposes only, it is to be understood that the present invention is no way intended to be or restricted thereto. Rather, it is apparent to those skilled in the art that the present invention can be varied and/or modified in many ways without departing from the scope of the inventive idea as disclosed herein.

## Claims

1. An apparatus, comprising:
a load modulation amplification structure for amplifying an input signal, including
a main amplifier and a plurality of at least two peak amplifiers, which are connected in parallel to each other, wherein the main amplifier and the plurality of peak amplifiers are arranged to interact in a load modulation operation, and
a star-like combining structure for generating an output signal by combining outputs of the load modulation amplification structure, including
at least four quarter-wavelength impedance transformers, wherein at least three of the transformers are connected to a respective one of the main amplifier and the plurality of peak amplifiers of the load modulation amplification structure, one of the transformers is connected to an output of the combining structure, and all of the transformers are connected in a star-like manner to a common node.

2. The apparatus according to claim 1, wherein
the main amplifier and the plurality of peak amplifiers of the load modulation amplification structure are arranged to amplify respective in-phase portions of the input signal.

3. The apparatus according to claim 1 or 2, the load modulation amplification structure includes:
a coupler for receiving the input signal and coupling respective portions of the input signal to the main amplifier and the plurality of peak amplifiers of the load modulation amplification structure such that all of the coupled portions of the input signal have the same phase.

4. The apparatus according to any one of claims 1 to 3, wherein the load modulation amplification structure and/or the star-like combining structure is configured such that a predefined set of the plurality of peak amplifiers is activated at predetermined back-off points.

5. The apparatus according to claim 4, wherein the predetermined back-off points for activating a predefined set of the plurality of peak amplifiers are defined on the basis of one or more of the desired power level of the output signal and amplification factors of the peak amplifiers.

6. The apparatus according to any one of claims 1 to 5, wherein
the combining structure is implemented using lumped elements.

7. The apparatus according to any one of claims 1 to 5, wherein
the combining structure is implemented using a discrete or distributed stripline structure.

8. The apparatus according to any one of claims 1 to 5, wherein
the combining structure is implemented using a discrete or distributed microstrip structure.

9. A method of operating a load modulation amplifier apparatus, said apparatus comprising:
a load modulation amplification structure for amplifying an input signal, including
a main amplifier and a plurality of at least two peak amplifiers, which are connected in parallel to each other, wherein the main amplifier and the plurality of peak amplifiers are arranged to interact in a load modulation operation, and
a star-like combining structure for generating an output signal by combining outputs of the load modulation amplification structure, including
at least four quarter-wavelength impedance transformers, wherein at least three of the transformers are connected to a respective one of the main amplifier and the plurality of peak amplifiers of the load modulation amplification structure, one of the transformers is connected to an output of the combining structure, and all of the transformers are connected in a star-like manner to a common node,
the method comprising:
activating a predefined set of the plurality of peak amplifiers at predetermined back-off points.

10. The method according to claim 9, wherein the predetermined back-off points for activating a predefined set of the plurality of peak amplifiers are defined on the basis of one or more of the desired power level of the output signal and amplification factors of the peak amplifiers.

11. The method according to claim 9 or 10, wherein
the main amplifier and the plurality of peak amplifiers of the load modulation amplification structure are operated to amplify respective in-phase portions of the input signal.

12. The method according to any one of claims 9 to 11, further comprising:
coupling, via a coupler, respective portions of the input signal to the main amplifier and the plurality of peak amplifiers of the load modulation amplification structure such that all of the coupled portions of the input signal have the same phase.
